Europäisches Patentamt

European Patent Office

Office européen des brevets

(19)

(11) Numéro de publication: **0 180 487**
A1

# (12) DEMANDE DE BREVET EUROPEEN

(21) Numéro de dépôt: 85401700.1

(22) Date de dépôt: 30.08.85

(51) Int. Cl.⁴: **H 03 K 17/08,** H 03 K 17/10

(30) Priorité: 03.09.84 FR 8413571

(43) Date de publication de la demande: 07.05.86
Bulletin 86/19

(84) Etats contractants désignés: **AT BE CH DE GB IT LI LU NL SE**

(71) Demandeur: **Etablissement public dit: CHARBONNAGES DE FRANCE, 9, Avenue Percier, F-75008 Paris (FR)**

(72) Inventeur: **Marget, Christian, 6, rue Jacques Taffenel, F-60550 Verneuil-en-Halatte (FR)**
Inventeur: **Rose, Gérard, 100, rue Aristide Briand, F-60470 Villers St Paul (FR)**

(74) Mandataire: **Rinuy, Santarelli, 14, avenue de la Grande Armée, F-75017 Paris (FR)**

(54) Circuit de puissance et dispositif de déclenchement le comportant.

(57) L'invention concerne un circuit de puissance comportant un circuit d'amplification de courant monté entre une ligne de potentiel minimal et une ligne de potentiel maximal, caractérisé en ce qu'il comporte en outre, monté entre ces lignes (5, 6), avec ce circuit d'amplification ($T_2$) appelé circuit principal, un circuit de protection ($T_3$) comportant une borne de commande, et un circuit de déclenchement et de répartition ($R_6$, $D_2$, $R_5$, $D_3$) monté en parallèle sur ces circuits d'amplification, adapté à neutraliser ledit circuit de protection, par action sur sa borne de commande, lorsque la tension aux bornes du circuit principal est inférieure à une valeur de seuil, puis à activer ce circuit de protection lorsque la tension aux bornes du circuit principal atteint cette valeur de seuil, tout en maintenant cette tension aux bornes du circuit principal dans un rapport approximativement constant vis-à-vis de la tension existant entre les lignes de potentiel (5, 6).

Application notamment à la commande, avec sécurité positive, de circuits d'alarme, à l'aide par exemple de signaux logiques.

"Circuit de puissance et dispositif de déclenchement le comportant"

La présente invention concerne un circuit de puissance à amplification de courant, ainsi que l'application de ce circuit dans un dispositif de déclenchement sélectif (relais statique), notamment adapté à commander le déclenchement d'une alarme.

On connaît déjà des circuits de puissance à amplification par transistor qui comportent une pluralité de transistors bipolaires, montés par leurs collecteurs et leurs émetteurs entre une ligne de potentiel maximal et une ligne de potentiel minimal et connectés par montage en cascade, mais ces circuits nécessitent la mise en oeuvre d'un nombre important de transistors dès que l'on veut pouvoir supporter une différence de potentiel nettement supérieure à la différence maximale de potentiel admissible par chacun des transistors entre son collecteur et son émetteur, par exemple sensiblement égale au double de cette différence maximale admissible.

L'invention a pour objet un circuit de puissance à amplification de courant qui puisse supporter, avec un nombre limité de composants, une différence globale de tension sensiblement supérieure à la tension maximale admissible par les composants pris individuellement.

L'invention a également pour objet un dispositif de déclenchement sélectif ou relais statique équipé d'un circuit de puissance du type précité, qui soit adapté à ne fournir de puissance qu'en présence d'un signal d'entrée, assurant ainsi une commande à sécurité positive du circuit d'utilisation à déclencher. Ce dernier est parfois lui-même à sécurité positive ; dans le cas d'un circuit d'alarme, un dispositif d'alarme est ainsi déclenché lorsque ledit circuit d'alarme cesse d'être alimenté à travers le circuit de puissance.

L'invention vise en outre un dispositif de déclenchement du type précité adapté à être commandé par des signaux logiques.

L'invention porte aussi sur un dispositif du type précité adapté à établir une isolation galvanique entre les signaux logiques d'entrée et le circuit de puissance.

L'invention vise aussi un dispositif de déclenchement commutable adapté à réagir à des signaux logiques d'entrée suivant plusieurs modes prédéterminés de fonctionnement.

L'invention propose à cet effet un circuit de puissance comportant un circuit d'amplification de courant monté entre une ligne de potentiel minimal et une ligne de potentiel maximal, caractérisé en ce qu'il comporte en outre, monté entre ces lignes en série, avec ce circuit d'amplification appelé circuit principal, un circuit de protection comportant une borne de commande, et un circuit de déclenchement et de répartition monté en parallèle sur ces circuits, adapté à neutraliser ledit circuit de protection, par action sur sa borne de commande, lorsque la tension aux bornes du circuit principal est inférieure à une valeur de seuil, puis à activer ce circuit de protection lorsque la tension aux bornes du circuit principal atteint cette valeur de seuil, tout en maintenant cette tension aux bornes du circuit principal dans un rapport approximativement constant vis-à-vis de la tension existant entre les lignes de potentiel. Un tel circuit permet l'obtention d'une différence globale de tension élevée, puisque les tensions aux bornes du circuit principal et du circuit de protection s'ajoutent, mais assure une sauvegarde de ces circuits puisque la tension aux bornes du circuit principal est maintenue au-dessous d'un seuil critique.

Selon des dispositions avantageuses de l'invention, le circuit principal est un transistor bipolaire monté entre les lignes de potentiel par son émetteur et son collecteur, le circuit de protection du circuit principal est un transistor à effet de champ dont la porte (ou grille) constitue ladite électrode de commande, et le circuit de déclenchement et de répartition comporte un détecteur de tension, tel qu'une diode ZENER, monté à la fois entre les bornes du circuit principal d'amplification, et entre l'électrode de commande du circuit de protection et le point de jonction de ce dernier avec le circuit principal. Cet élément est avantageusement inclus dans une chaîne résistive adaptée à maintenir les tensions existant aux bornes de ces circuits, lorsque le circuit de protection n'est pas neutralisé, dans un rapport voisin de celui des tensions maximales admissibles par ces derniers ; l'invention permet ainsi d'atteindre de manière fiable une tension globale à peine inférieure à la somme des tensions maximales associées à ces circuits.

Il est à noter que l'invention permet un passage de courant sous forte tension tout en profitant du fort gain en courant à faibles signaux que possèdent les transistors à tension maximale relativement faible, ce que ne permettrait pas un transistor à tension maximale élevée.

Selon d'autres dispositions avantageuses de l'invention, un circuit de puissance du type précité est intégré dans un dispositif de déclenchement, par exemple commandé par signaux binaires, qui comporte entre ses bornes d'entrée et le circuit de puissance un circuit d'isolation galvanique, avantageusement du type photocoupleur ; le circuit de déclenchement assure avantageusement un nombre pair d'inversions de signal en sorte de ne permettre le passage d'un courant dans le circuit de puissance qu'en présence d'un signal dans le circuit d'isolation. Lorsqu'il s'agit de commander le déclenchement d'un circuit extérieur d'utilisation comportant une source de tension alternative, l'invention préconise que le dispositif de déclenchement précité comporte deux circuits de puissance montés en parallèle avec des polarités inverses en sorte de générer chacun, le cas échéant, un courant redressé correspondant respectivement aux alternances positives ou négatives associées à ladite source. Un commutateur est avantageusement incorporé entre les entrées associées à chacun des circuits de puissance en sorte, soit de déconnecter l'un des circuits, soit d'appliquer aux circuits les mêmes signaux logiques de commande, soit d'appliquer à ces circuits des signaux logiques de commande complémentaire.

D'autres objets, caractéristiques et avantages ressortent de la description qui suit, donnée à titre d'exemple non limitatif, en regard des dessins annexés sur lesquels :

- la figure 1 est un schéma électrique d'un dispositif de déclenchement comportant un circuit de puissance selon l'invention ; et

- la figure 2 est un schéma synoptique d'un autre dispositif de déclenchement, comportant deux circuits de puissance selon l'invention.

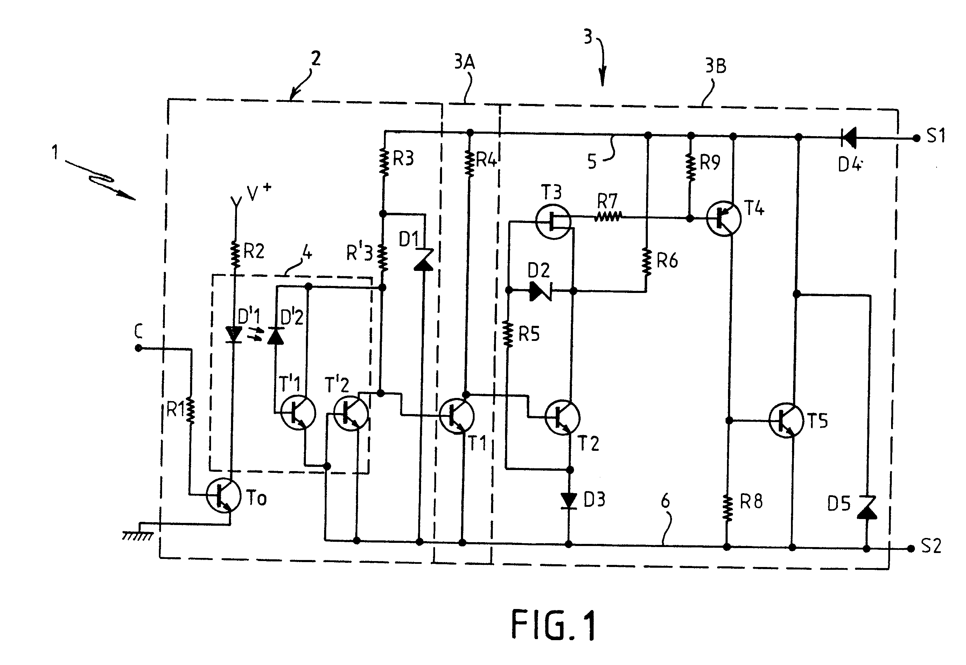

La figure 1 représente, à titre d'exemple d'application de

4

l'invention, un dispositif de déclenchement 1 admettant deux bornes d'entrée, dont l'une porte la référence C et l'autre est à la masse, ainsi que deux bornes de sortie $S_1$ et $S_2$.

Le dispositif 1 comporte principalement un circuit d'entrée 2 et un circuit de puissance 3 qui peut lui-même se décomposer en un étage d'inversion 3A et un étage amplificateur de puissance 3B.

Le circuit d'entrée 2 comporte un circuit de couplage 4 adapté à assurer une isolation galvanique entre ses bornes d'entrée et de sortie et un circuit-interrupteur adapté à appliquer un signal en tout ou rien à l'entrée de ce circuit de couplage. Ce circuit-interrupteur comporte principalement une source d'alimentation, notée $V^+$, et un transistor bipolaire (à jonctions) $T_o$, ici de type NPN, dont la base est reliée par une résistance $R_1$ à la borne C, dont l'émetteur est à la masse, et dont le collecteur est à une borne d'entrée du photocoupleur 4, l'autre borne d'entrée étant reliée à la source d'alimentation $V^+$ par une résistance $R_2$.

Le coupleur 4 comporte principalement une diode émettrice de lumière $D'_1$ et une photodiode $D'_2$ ; $D'_1$ est branchée en direct entre la source $V^+$ et le transistor $T_o$, tandis que $D'_2$ est branchée en inverse entre le collecteur et la base d'un transistor bipolaire $T'_1$, de type NPN, dont l'émetteur est à son tour à la base d'un transistor bipolaire $T'_2$ similaire. $T'_1$ et $D'_2$ jouent conjointement le rôle d'un phototransistor.

Le photocoupleur 4 est branché au sein du circuit d'entrée 2 de telle sorte que les collecteurs et les émetteurs des transistors $T'_1$ et $T'_2$ sont respectivement reliés entre eux : les collecteurs sont connectés par une chaîne résistive $R_3$-$R'_3$ à une ligne 5 de potentiel maximum tandis que les émetteurs sont reliés à une ligne 6 de potentiel minimal. Une diode ZENER formant limiteur de tension est branchée entre le point commun des résistances $R_3$ et $R'_3$, et la ligne 6 de potentiel minimal.

L'étage d'inversion 3A par lequel commence le circuit de puissance 3 comporte un circuit inverseur $T_1$ monté entre les lignes de potentiel 5 et 6, ayant une électrode de commande reliée aux collecteurs des transistors $T'_1$ et $T'_2$. Tel que représenté, ce circuit est constitué par un transistor $T_1$ de type NPN commandé par sa base, dont le collecteur est à la ligne 5 de potentiel maximal au travers d'une résistance $R_4$ et dont l'émetteur est à la ligne 6 de potentiel minimal. Le collecteur de $T_1$ constitue une borne d'entrée pour l'étage amplificateur 3B.

Cet étage comporte un circuit principal d'amplification, un circuit de protection et une chaîne résistive, montés en série entre les lignes de potentiel 5 et 6, ainsi qu'une chaîne de composants montée en parallèle sur ces circuits en étant reliée à leur point commun. Le circuit principal est relié au circuit-inverseur $T_1$ et à la ligne 6 de potentiel minimal ; tel que représenté, ce premier circuit comporte un seul transistor $T_2$, de type NPN, dont la base est reliée au collecteur de $T_1$ et dont l'émetteur est relié à la ligne 6 par une diode $D_3$ branchée en direct de manière à être à un potentiel supérieur de 0,6 V à celui de cette ligne . L'autre circuit, dit de protection, monté entre la ligne 5 de potentiel maximal et le point de tension maximale du premier circuit, en l'occurrence le collecteur de $T_2$, est commandé par la chaîne de composants montée en parallèle en fonction de la tension aux bornes du circuit principal ; la borne de commande que comporte ce second circuit est reliée à sa borne de potentiel minimal par un élément détecteur de tension également monté en série avec un élément résistif, entre les bornes du premier circuit. Tel que représenté, ce second circuit comporte un transistor à effet de champ $T_3$ à canal N dont la grille est la borne de commande dudit second circuit ; le drain de ce transistor est relié à la ligne 5 de potentiel maximal par une chaîne de deux résistances $R_7$ et $R_9$. La chaîne de composants montée en parallèle sur ces circuits comporte, à partir de la ligne 5 vers la ligne 6, une résistance $R_6$ connectée au point commun des deux circuits d'amplification $T_2$ et $T_3$, une diode ZENER $D_2$ formant détecteur de tension montée entre ce point commun et la grille de $T_3$ en série avec une résistance $R_5$, entre ce point commun et l'émetteur de $T_2$, puis une diode $D_3$.

Ces circuits en série commandent un circuit d'amplification de courant ici constitué de deux transistors $T_4$ et $T_5$ de types

opposés, PNP et NPN respectivement, montés en cascade. La base de $T_4$ est au point commun des résistances $R_7$ et $R_9$, son émetteur est à la ligne 5, et son collecteur est relié à la ligne 6 par une résistance $R_8$ ; la base de $T_5$ est reliée au collecteur de $T_4$ et son collecteur et son émetteur sont reliés directement aux lignes 5 et 6 respectivement. Une diode ZENER $D_5$ formant limiteur de tension est montée entre le collecteur et l'émetteur de $T_5$. Une diode $D_4$ est montée entre $S_1$ et la ligne 5 de potentiel maximal en sorte d'empêcher tout passage de courant vers $S_1$ depuis cette ligne 5.

A titre d'exemple : le photocoupleur 4 correspond à la référence 6N139 (grande sensibilité d'entrée) ; les diodes ZENER $D_1$ et $D_2$ sont limitées à 5,1 V ; la diode $D_4$ a la référence 1N4007 ; la diode $D_5$ est limitée à 80 V ; les transistors $T_1$ et $T_2$ ont la référence 2N930 (tension limite de 45 V), $T_3$ a la référence 2N4338 (tension limite de 50 V et tension de coupure garantie inférieure à 1 V), $T_4$ et $T_5$ ont la référence 2N4920 et 2N4923 respectivement. Les résistances $R_3$, $R'_3$ et $R_6$ ont des valeurs de 1 M$\Omega$; $R_4$, 2 M$\Omega$; $R_5$, 820 k$\Omega$; $R_7$, 100$\Omega$; $R_8$, 10 k$\Omega$; et $R_9$, 100 k$\Omega$. On peut vérifier que le circuit de la figure 1, avec des composants ayant les caractéristiques précitées, permet de piloter une puissance importante (70 V - 300 mA) avec un courant de commande d'environ 100$\mu$A, soit une puissance de moins d'1m W. Il est à noter que le circuit de puissance selon l'invention permet de piloter une tension nettement supérieure aux tensions maximales admissibles par le photocoupleur 4, par $T_1$ et surtout par les transistors $T_2$ et $T_3$.

Le dispositif de déclenchement ou relais statique de la figure 1 est adapté à répondre à des signaux logiques de commande appliqués en C, correspondant à une différence de potentiel, soit positive, soit nulle entre C et la masse.

Lorsque C est à un potentiel suffisamment supérieur à celui de la masse, $T_0$ est passant et la diode émettrice de lumière $D'_1$ émet des photons vers $D'_2$ ; compte tenu du montage de $D'_2$, $T'_1$ est passant. La diode $D_1$ a pour fonction de limiter le courant dans $R'_3$, de manière à permettre à $T'_1$ de commander $T_1$. La tension d'alimentation de la source A est choisie de manière à ce que le courant traversant $D'_1$ induise aux bornes de $T_1$ une tension de saturation suffisamment faible pour bloquer $T_1$ (inférieur à 0,2 V par exemple). $T_2$ est alors passant ; sa tension de saturation, qui est appliquée par $D_2$ à la grille de $T_3$, est insuffisante pour bloquer ce dernier qui présente ainsi une résistance faible, très inférieure à la résistance de $R_9$. La majeure partie du courant de commande est amplifiée par $T_4$ et $T_5$ et une chute de tension faible, donc une faible tension résiduelle est établie entre $S_1$ et $S_2$.

Lorsque, par contre, le transistor $T_o$ (tension en C égale à celle de la masse) est bloqué, la photodiode $D'_2$ ne reçoit pas de photons et ne débite aucun courant : $T'_1$ est bloqué ; la jonction base-émetteur de $T_1$ maintient à 0,6 V la tension collecteur-émetteur de $T'_1$, quelle que soit la tension commandée. $T_1$ devient passant et $T_2$ se bloque. La tension aux bornes de $T_2$ monte rapidement ainsi que la tension aux bornes de $D_2$. Lorsque cette dernière, en augmentant vers son seuil de tension (5,1 V), dépasse la tension de coupure de $T_3$, $T_3$ se bloque, et la tension à ses bornes croît en s'ajoutant à la tension aux bornes de $T_2$. La diode ZENER $D_5$ limite la tension totale entre les lignes 5 et 6 à 80 V. La chaîne des composants $R_5$-$R_6$-$D_2$-$D_3$ tend à maintenir le potentiel du collecteur de $T_2$ à la moitié environ de cette tension totale, grâce à quoi la tension aux bornes de chacun des transistors $T_2$ et $T_3$ reste inférieure à leurs tensions maximales admissibles, qui sont du même ordre dans l'exemple qui vient d'être décrit. On vérifie donc que le circuit de puissance de l'invention permet d'obtenir sans risques une tension très supérieure aux tensions maximales admissibles par chacun des transistors $T_2$ et $T_3$. On notera que la tension aux bornes de $D_2$ varie avec la tension aux bornes de $T_2$ ; le déclenchement de $T_3$ qui intervient lorsque la tension aux bornes de $D_2$ dépasse le seuil de coupure de $T_3$, intervient donc pour un seuil de tension aux bornes de $T_2$.

On notera que $T_1$ assure bien une fonction d'inversion. Sa présence est rendue nécessaire pour permettre une commande à sécurité positive d'un quelconque circuit extérieur branché à la sortie du circuit de puissance : en présence d'un courant de commande, le relais statique 1 permet le passage d'un courant extérieur. $T_1$ compense une première inversion introduite par le choix du montage employé ; il est soumis à une tension maximale qui reste faible (1,1 V) grâce à $T_2$ et $D_3$.

$T_2$, $T_4$ et $T_5$, montés en cascade via $T_3$, assurent une amplification du courant de commande.

$T_3$ agit en résistance variable et a pour effet d'empêcher la tension aux bornes de $T_2$ de devenir trop importante si celui-ci est bloqué. La chaîne des composants $R_6-D_2-R_5-D_3$ constitue un circuit de sauvegarde pour $T_2$ grâce à la commande de $T_3$ par $D_2$ qui fait supporter à $T_3$ une partie de la tension d'alimentation lorsque la tension aux bornes de $T_2$ devient trop importante ; cette chaîne constitue un circuit de déclenchement de $T_3$ et de répartition de tension entre $T_2$ et $T_3$.

La diode $D_5$ élimine les surtensions qui pourraient se produire lors d'une coupure avec une charge inductive (relais). $D_4$ protège le circuit contre les tensions négatives.

On notera que $T'_2$, prévu dans un photocoupleur du type 6N139 est inutilisé, de manière à n'obtenir, sur la base de $T_1$, qu'une faible tension de commande, lorsque $T'_1$ est saturé ; $T'_2$ peut être supprimé.

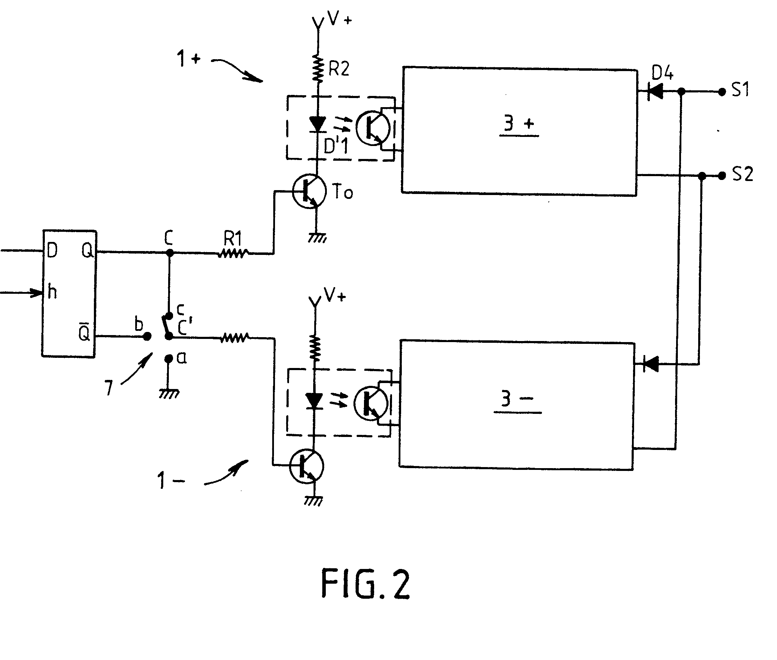

La figure 2 représente un dispositif de déclenchement analogue à celui de la figure 1 mais dans une version plus élaborée, adaptée à commander un circuit de charge faisant intervenir entre $S_1$ et $S_2$ des signaux alternatifs, l'ensemble $D'_2-T_1$ étant représenté schématiquement par un phototransistor.

Ce dispositif amélioré comporte en fait deux dispositifs élémentaires 1+ et 1- analogues à celui de la figure 1, adaptés à laisser passer (ou au contraire à bloquer) des alternances positives ou des alternances négatives respectivement. Ces dispositifs élémentaires diffèrent principalement par leur mode de connection aux bornes de sortie $S_1$ et $S_2$, ainsi qu'il ressort de l'examen à la figure 2 des liaisons des rectangles 3+ et 3- (représentant les circuits de puissance des dispositifs de déclenchement 1+ et 1-) aux bornes $S_1$ et $S_2$ ; les diodes $D_4$ qui appartenaient au circuit de puissance 3 de la figure 1 ont été extraites des circuits 3+ et 3- pour bien faire ressortir cet aspect.

Les dispositifs de déclenchement 1+ et 1- ont des bornes d'entrée C et C', respectivement, et des bornes d'entrée reliées à la masse.

Dans l'exemple de la figure 2, les dispositifs élémentaires 1+ et 1- sont branchés à la sortie d'un circuit logique ayant deux sorties complémentaires Q et $\bar{Q}$. Un commutateur 7 permet avantageusement de modifier le branchement de l'un des dispositifs élémentaires, le dispositif 1- en l'occurrence. Ce commutateur admet trois positions. En une première position, a, C' est mis à la masse, ce qui revient à neutraliser le dispositif 1-. En une seconde position, b, les dispositifs 1+ et 1- sont commandés par des signaux logiques complémentaires et un seul de ces dispositifs fonctionne à un instant donné. En une troisième position, c, les dispositifs 1+ et 1- sont commandés par le même signal logique et ont des cycles synchronisés de fonctionnement.

Il va de soi que la description qui précède n'a été proposée qu'à titre d'exemple illustratif non limitatif et que de nombreuses variantes peuvent être proposées par l'homme de l'art sans sortir du cadre de l'invention. Ainsi, notamment, la structure du circuit principal et du circuit de protection qui, à la figure 1, ne comportent qu'un seul transistor chacun, peut être rendue plus complexe ; lorsqueles tensions maximales admissibles par ces circuits ne sont pas égales, il convient de modifier en conséquence les composants de la chaîne de sauvegarde associée en sorte de maintenir le potentiel du point commun à ces circuits, vis-à-vis de la tension globale, dans un rapport voisin du rapport desdites tensions maximales admissibles. Un rapport différent est bien sûr possible quoiqu'a priori désavantageux.

Le nombre, la répartition et les caractéristiques des divers composants (résistances, diodes, etc ...) sont bien sûr à déterminer en fonction des besoins.

10

REVENDICATIONS

1. Circuit de puissance comportant un circuit d'amplification de courant monté entre une ligne de potentiel minimal et une ligne de potentiel maximal, caractérisé en ce qu'il comporte en outre, monté entre ces lignes (5,6) en série avec ce circuit d'amplification $(T_2)$ appelé circuit principal, un circuit de protection $(T_3)$ comportant une borne de commande, et un circuit de déclenchement et de répartition $(R_6,D_2,R_5,D_3)$, monté en parallèle sur le circuit principal et le circuit de protection, adapté à neutraliser ledit circuit de protection, par action sur sa borne de commande, lorsque la tension aux bornes du circuit principal est inférieure à une valeur de seuil, puis à activer ce circuit de protection lorsque la tension aux bornes du circuit principal atteint cette valeur de seuil, tout en maintenant cette tension aux bornes du circuit principal dans un rapport approximativement constant vis-à-vis de la tension existant entre les lignes de potentiel (5,6).

2. Circuit selon la revendication 1, caractérisé en ce que le circuit principal d'amplification de courantcomporte un transistor bipolaire $(T_2)$ commandé par sa base.

3. Circuit selon la revendication 1 ou la revendication 2, caractérisé en ce que le circuit de protection comprend un transistor à effet de champ $(T_3)$ dont la grille constitue ladite borne de commande.

4. Circuit selon l'une quelconque des revendications 1 à 3, caractérisé en ce que le circuit de déclenchement et de répartition comporte un élément détecteur de tension $(D_2)$ monté entre le point commun du circuit de protection $(T_3)$ et du circuit principal $(T_2)$ et la borne de commande du circuit de protection et, en série avec un élément résistif, entre ce point commun et la borne du circuit principal qui est reliée à la ligne (6) de potentiel minimum.

5. Circuit selon la revendication 4, caractérisé en ce que l'élément détecteur de tension est une diode ZENER $(D_2)$.

11

6. Circuit selon l'une quelconque des revendications 1 à 5, caractérisé en ce que la tension aux bornes du circuit principal est maintenue, lorsque le circuit de protection est activé, dans un rapport prédéterminé vis-à-vis de la tension existant entre les deux lignes.

7. Circuit selon la revendication 6, caractérisé en ce que ce rapport est approximativement égal au rapport de la tension maximale admissible par le circuit principal à la somme de cette dernière et de la tension maximale admissible par le circuit de protection.

8. Dispositif de déclenchement comportant un circuit de puissance selon l'une quelconque des revendications 1 à 7, caractérisé en ce qu'il comporte en outre un circuit d'isolation galvanique (4).

9. Dispositif selon la revendication 8, caractérisé en ce que ce circuit d'isolation galvanique comporte un photocoupleur (4).

10. Dispositif selon la revendication 8 ou la revendication 9, caractérisé en ce que, pour assurer une sécurité positive, le circuit d'isolation galvanique (4) et le circuit de puissance (3) sont connectés ($T_1$) en sorte que le circuit de puissance est passant lorsque le circuit d'isolation galvanique est traversé par un courant de commande.

11. Dispositif selon l'une quelconque des revendications 8 à 10, caractérisé en ce qu'il comporte deux circuits de puissance analogues (3+, 3-), dont les sorties sont accouplées suivant des polarités opposées.

12. Dispositif selon la revendication 11, adapté à être commandé par un circuit logique muni de deux bornes de sortie complémentaires, caractérisé en ce que l'entrée de l'un (3+) des circuits de puissance est reliée à l'une des bornes de sortie du circuit logique, et que l'autre (3-) des circuits de puissance est relié à un commutateur (7) à trois positions adapté à lui appliquer, soit un signal constamment nul, soit le signal appliqué au premier circuit de puissance, soit le signal complémentaire de ce dernier.

FIG.1

1/2

0180487

FIG.2

**Office européen des brevets**

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 048 758 (INTERNATIONAL RECTIFIER CORP.) <br> * Page 6, ligne 9 - page 11, ligne 13; figure 3 * | 1,3-5 | H 03 K 17/08 <br> H 03 K 17/10 |
| A | FR-A-1 540 797 (TELEFUNKEN) <br> * Page 1, colonne de droite, ligne 16 - page 2, colonne de gauche, ligne 14; figure 1 * | 1,2 | |
| A | FR-A-1 279 329 (BEREX ESTABLISHMENT) <br> * Page 1, colonne de droite, dernier alinéa - page 2, colonne de gauche, ligne 35; figure 1 * | 1,2,6, 7 | |
| A | US-A-3 792 291 (ZIETEMAN) <br> * Colonne 2, ligne 65 - colonne 4, ligne 45; figure * | 1,2 | DOMAINES TECHNIQUES RECHERCHES (Int. Cl.4) <br><br> H 03 K <br> H 03 F |

Le présent rapport de recherche a été établi pour toutes les revendications

| Lieu de la recherche | Date d'achèvement de la recherche | Examinateur |
|---|---|---|
| LA HAYE | 10-12-1985 | CANTARELLI R.J.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

OEB Form 1503 03 82